# EUROPÄISCHE PATENTSCHRIFT

(11) **EP 0 685 765 B1**
(45) Veröffentlichungstag und Bekanntmachung des Hinweises auf die Patenterteilung: **06.09.2000**
(21) Anmeldenummer: 95107860.9
(22) Anmeldetag: 23.05.1995
(51) Int. Cl.: G03F 3/10

(54) **Ein- und mehrfarbige Farbprüfbilder von Vorlagen mit hoher Auflösung sowie Verfahren und Mittel für deren Herstellung**
Monochromatic and polychromatic proofs of high resolution masters and process and means of their preparation
Epreuves monocromatiques et polychromatiques des masques à haute résolution, procédé et moyens de leur préparation

(30) Priorität: 03.06.1994 DE 4419597
(43) Veröffentlichungstag der Anmeldung: 06.12.1995
(73) Patentinhaber: DU PONT DE NEMOURS (DEUTSCHLAND) GMBH, 61343 Bad Homburg v.d.H. (DE); E.I. DUPONT DE NEMOURS AND COMPANY, Wilmington, Delaware 19898 (US)
(72) Erfinder: Metzger, Bernhard, Dr., D-64291 Darmstadt (DE)

(56) Entgegenhaltungen:
- EP-A- 0 644 459
- JP-A- 6 064 036

## Beschreibung

Die vorliegende Erfindung betrifft ein- und mehrfarbige Farbprüfbilder mit hoher Auflösung für die graphische Industrie und Verfahren zu ihrer Herstellung.

In der Reproduktionstechnik werden gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft, ob das spätere Druckergebnis eine tonwertrichtige Reproduktion der Vorlage darstellt.

In solchen Farbprüfverfahren finden beispielsweise strahlungsempfindliche Aufzeichnungsmaterialien Verwendung, bei denen zur Bilderzeugung Unterschiede in der Klebrigkeit der belichteten und unbelichteten Bereiche der strahlungsempfindlichen Schicht ausgenutzt werden. So ist z.B. aus den deutschen Patentschriften DE-C 12 10 321, DE-C 19 04 058, DE-C 19 04 059 und DE-C 20 04 214 sowie in US 43 56 253 und EP-A 02 43 933 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen Photopolymerisationsinitiator enthält, durch bildmäßige Belichtung gehärtet wird, wobei die belichteten Bildteile ihre Klebrigkeit verlieren.

Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden.

Negative Bilder der Vorlage erhält man, wenn man die z.B. in den deutschen Patentschriften DE-C 27 58 209, DE-C 30 23 247 und DE-C 34 29 615 beschriebenen lichtempfindlichen Materialien verwendet. Diese Aufzeichnungsmaterialien enthalten als lichtempfindliche Komponente entweder eine Dihydropyridinverbindung oder ein System aus einer Dihydropyridinverbindung und einer Hexarylbisimidazolverbindung.

Das Aufbringen der überwiegend aus feinteiligen Pulvern bestehenden Tonermaterialien kann durch Bestäuben der bildmäßig belichteten Oberfläche mit dem Toner erfolgen, wie sie z.B. in DE-C 29 46 896 und US 39 09 282 beschrieben sind. Nach einer anderen Ausführungsform kann sich der Toner auch lose gebunden auf einem gesonderten Träger befinden und durch Inkontaktbringen dieses Trägers mit der bildmäßig belichteten Schicht übertragen werden. Solche pigmentierten Trägerschichten werden in DE-C 36 25 014 und DE-C 39 41 493 beschrieben.

Die strahlungsempfindlichen Aufzeichnungsmaterialien bestehen üblicherweise aus einem Schichtträger, einer strahlungsempfindlichen Schicht und einer Deckfolie. Diese Deckfolie wird abgezogen und das Material auf ein Bildträger auflaminiert bevor die bildmäßige Belichtung erfolgt. Der Schichtträger kann je nach Material vor oder nach der Belichtung abgezogen werden.

In der Reproduktionstechnik werden gegenwärtig standardmäßig Linienraster mit einer Auflösung von 60 Linien pro Zentimeter verwendet. Zur Herstellung besonders hochwertiger Drucke werden zudem Linienraster mit einer Auflösung von 80 Linien pro Zentimeter verwendet. Es besteht jedoch der Bedarf an der Verwendung von höher aufgelösten Rastern für besonders hochwertige Drucke. Beispiele für solche hochaufgelösten Raster sind Linienraster mit einer Auflösung von 100 oder 120 Linien pro Zentimeter sowie frequenzmodulierte Raster.

Die Verwendung von hochaufgelösten Rastern, insbesondere frequenzmodulierten Rastern in der Reproduktionstechnik wurde bisher durch das Fehlen geeigneter Farbprüfverfahren stark eingeschränkt. Die gegenwärtig am Markt befindlichen Farbprüfverfahren sind nicht in ausreichendem Maße in der Lage, dem späteren Druckergebnis entsprechende ein- oder mehrfarbige Farbprüfbilder herzustellen. Insbesondere die sehr kleinen Punkte der frequenzmodulierten Raster mit einem Punktdurchmesser von weniger als 25 µm und die 2%-Punkte der Linienraster mit einer Auflösung von mehr als 80 Linien pro Zentimeter werden mit den gängigen Farbprüfverfahren unzureichend erfaßt. Dies führt zu Farbprüfbilder, die der Fachmann als "unruhig" oder "fleckig" oder "wolkig" oder als mit "mottle" behaftet bezeichnet. Solche Farbprüfbilder sind zur Prüfung von Druckvorlagen ungeeignet.

Für den modernen Flachdruck werden daher von der graphischen Industrie Farbprüfverfahren für gerasterte Farbauszügen gefordert, mit denen Farbauszüge, welche mit Hilfe von Rastern mit hoher Auflösung hergestellt wurden, auf ihre Eignung zur Herstellung von Druckplatten hin überprüft werden können.

Bildträger für Farbprüfverfahren sind dem Fachmann bekannt. Es wurden aber bisher noch keine Bildträger für Farbprüfverfahren vorgeschlagen, welche eine originalgetreue Wiedergabe von hochaufgelösten Rastervorlagen mit einem Punktdurchmesser von weniger als 25 µm zulassen.

Aufgabe der vorliegenden Erfindung ist es daher, ein- und mehrfarbige Farbprüfbilder vorzuschlagen, welche einen hohe Auflösung aufweisen, sowie Verfahren zu deren Herstellung.

Diese Aufgabe wird gelöst durch ein- und mehrfarbige Farbprüfbilder nach Anspruch 1 bis 3, sowie Verfahren zur Herstellung von ein- und mehrfarbigen Farbprüfbildern gemäß der Ansprüche 4 bis 6.

Der Bildträger enthält ein gegebenenfalls zusammengesetztes Substrat, welches gegebenenfalls Beschichtungen auf der bildempfangenden Seite und/oder der ihr gegenüberliegenden, zweiten Seite aufweisen kann. Solche Beschichtungen des Substrats können beispielsweise antistatisch und/oder haftvermittelnd wirken, den optischen Punktzuwachs steuern und/oder Oberflächeneigenschaften wie Glanz und Glätte beeinflussen. Der Bildträger kann ansonsten beliebig viele Beschichtungen aufweisen. Die Beschichtungen des Bildträgers können Substanzen wie Farbmittel, Füller, optische Aufheller, UV-Absorber und Antistatikmittel enthalten. Die bildseitige Oberfläche des Bildträgers weist eine gemittelte Rauhtiefe Rz von maximal 1,1 µm auf. Besonders bevorzugt ist dabei der Bereich bis zu einer gemittelten Rauhtiefe Rz von maximal 0,6 µm. Am besten geeignet ist ein Bildträger, der auf seiner bildempfangenden Seite eine gemittelte Rauhtiefe Rz von weniger als 0,4 µm aufweist.

Die Dicke eines geeigneten Bildträgers ergibt sich für den Fachmann aus den mechanischen Anforderungen des jeweiligen Farbprüfverfahrens sowie der Ansprüche des jeweiligen Kundenkreises an das entsprechende, damit hergestellte ein- oder mehrfarbige Farbprüfbild. Einschränkungen der Dicke der Bildträger ergeben sich nur durch die Anforderungen der jeweiligen Farbprüfverfahren und den Verwendungszwecke des Farbprüfbildes.

Als Substrat für den Bildträger eignen sich beispielsweise zweiseitige flächenförmige Träger aus Papier, Pappe, Metalle, Folien oder Platten aus Polymeren wie z.B. Polyethylen, Polyester, Polyvinylchlorid und Polyamid. Das Substrat kann auch aus mehr als einem Material zusammengesetzt sein. Beispiel hierfür ist ein Papier, welches mit einer 175 µm dicken Polyesterfolie verbunden ist. Das Substrat kann sowohl transparent als auch undurchsichtig sein. Es kann Pigmente enthalten und/oder eingefärbt sein. Zur Herstellung von Farbprüfbildern nach einem Auswaschverfahren sind Träger besonders gut geeignet, die gegen die Auswaschlösungen resistent sind.

Besonders gut geeignete Substrate sind weiß eingefärbte Kunststoffolien , wie z. B. Polyesterfolien, insbesonders Polyethylenterephthalatfolien, mit einer Dicke von 50 µm bis 500 µm, mit einem Harz, wie z. B. Polyethylen oder Polypropylen, beschichtete Papiere mit einem Flächengewicht zwischen 50 g/m² und 500 g/m² sowie Kombinationen aus gegebenenfalls weiß eingefärbten Kunststoffolien und gegebenenfalls beschichteten Papieren mit einer Dicke von insgesamt 50 µm bis 600 µm.

Die bildseitige Oberfläche eines Bildträgers zeichnet sich durch die erfindungsgemäße gemittelte Rauhtiefe Rz aus. Eine oder beide Seiten des Bildträgers können bildseitige Oberfläche sein.

Die gemittelte Rauhtiefe Rz eines Bildträgers wird nach DIN 4768, Blatt 1 bestimmt. Als Meßgerät hierfür eignet sich zum Beispiel der Hommel Tester T20-DC in Verbindung mit dem Meßfühler TKL 100 (Hommelwerke GmbH, D-7730 Schwenningen).

Farbprüfbilder können unter Verwendung des erfindungsgemäßen Bildträgers mit Hilfe von verschiedenen Farbprüfverfahren hergestellt werden. Beispiele für solche Verfahren sind in EP-A 0 277 038 (Auswasch- und Übertragungsverfahren), EP-B 0 165 030 (Auswaschverfahren), EP-B 0 197 396, EP-A 0 514 186, EP-A 0 570 815, EP-A 0 573 013, EP-A 0 556 732, EP-A 0 487 797, und EP-A 0 443 802 beschrieben.

Als tonbare strahlungsempfindliche Gemische im Sinne dieser Erfindung können sowohl positiv tonbare, photohärtbare Systeme, wie sie z.B. in DE-C 12 10 321, DE-C 19 04 058 oder DE-C 20 04 214 genannt sind, als auch negativ tonbare, bei Bestrahlung klebrig werdende Systeme, wie sie z.B. in DE-C 27 58 209, DE-C 30 23 247 und DE-C 34 29 615 beschrieben sind, verwendet werden. Die genannten negativ tonbaren Aufzeichnungsmaterialien enthalten entweder eine Dihydropyridinverbindung oder ein lichtempfindliches System aus einer Hexarylbisimidazolverbindung und einem Dihydropyridin.

Bevorzugt werden aber positiv tonbare photopolymersierbare Aufzeichnungsmaterialien für die vorliegende Erfindung verwendet. Insbesondere die in EP-A 02 43 932 und EP-A 02 43 933 beschriebenen Materialien werden bevorzugt eingesetzt. Diese Materialien enthalten ein polymeres Bindemittel, mindestens eine photopolymersierbare Verbindung, einen Photoinitiator und ggf. weitere Hilfsstoffe wie Weichmacher, Sensibilisatoren, Füllstoffe, Antioxidantien und optische Aufheller.

Bevorzugte Bindemittel sind die in der EP-A 02 43 933 genannten Polymere mit einer Glastemperatur < 70° C, bzw. < 80° C bei Polymergemischen, und mit salzbildenden Gruppen, welche durch Metallionen ionisch vernetzt sind. Besonders bewährt haben sich thermoplastische Bindemittel auf Acrylat und/oder Methacrylatbasis, welche die salzbildenden Gruppen z.B. in Form von Acrylsäure oder Methacrylsäure enthalten. Die Metallionen sind bevorzugt Magnesium, Kalzium, Strontium, Barium, Aluminium, Zinn, Zink, Cadmium, Titan, Zirkon und Mangan, die als Salze, bevorzugt als Chelate zugesetzt werden.

Die tonbaren strahlungsempfindlichen Gemische können nach bekannten Methoden auf geeignete vorzugsweise transparente, Schichtträger aufgetragen und anschließend getrocknet werden. Geeignete Schichtträger sind beispielsweise Kunststoffolien aus Polyethylen, Polypropylen, Polyamid und Polyester. Bevorzugt wird eine Polyethylenterephthalatfolie verwendet.

Bei der Verwendung von nichttransparenten Schichtträgern, werden diese vor der bildmäßigen Belichtung abgezogen.

Die Seite der Aufzeichnungsschicht, die dem Schichtträger abgewandt ist, wird mit einer flexiblen Deckschicht, beispielsweise einer dünnen Folie aus Polystyrol, Polyethylen, Polypropylen oder Polyethylenterephthalat versehen. Bevorzugt wird eine Polypropylenfolie verwendet.

Die Schichtdicke der Aufzeichnungsschicht liegt bevorzugt zwischen 2 µm und 100 µm. Besonders gut geeignet sind Schichtdicken zwischen 2 µm und 12 µm.

Die strahlungsempfindlichen Materialien besitzen ihre maximale Empfindlichkeit im UV-Bereich, bevorzugt im Wellenlängenbereich zwischen 250 und 450 nm. Zur Belichtung sind daher alle Strahlungsquellen geeignet, die eine wirksame Menge dieser Strahlung liefern; beispielsweise Xenonlampen, Quecksilberdampflampen und Kohlebogenlampen, Laser Fluoreszenzlampen mit UV-Strahlung emittierenden Leuchtstoffen und Elektronenblitzgeräte.

Das Tonen der bildmäßig belichteten Aufzeichnungsschicht kann sowohl durch Bestäuben mit überwiegend aus feinteiligen Pulvern bestehenden Tonermaterialien erfolgen, wie sie z.B. aus DE-C 29 46 896 und US 39 09 282 bekannt sind, wie auch mit pigmentierten Tonungsfolien, die das Tonermaterial lose gebunden auf einem gesonderten Träger enthalten. Solche Tonungsfolien werden z.B. in DE-C 39 41 493 und DE-C 36 25 014 und DE-C 37 06 528 beschrieben.

Das Hauptanwendungsgebiet der Erfindung liegt in der Herstellung von Ein- und Mehrfarbenbildern und in der Verwendung für Farbprüfverfahren. Beispiele solcher Farbprüfverfahren sind in EP-A 03 52 055 (Positiv arbeitendes Abziehverfahren), DE-A 42 09 873 (Negativ arbeitendes Farbübertragungsverfahren), EP-A 04 03 128 (Negativ arbeitendes Auswasch- und Übertragungsverfahren), EP-A 05 14 186 (Negativ arbeitendes Abziehverfahren, DE-A 37 20 724, US 36 71 236, DE-A 41 10 057 (Auswasch- und Übertragungsverfahren) sowie EP-A 03 57 325 (Positiv arbeitendes Auswaschverfahren) beschrieben.

Die Durchführung eines Farbprüfverfahrens gemäß der vorliegenden Erfindung kann beispielsweise die folgenden Verfahrensschritte umfassen.

Nach dem Entfernen der Deckfolie wird ein positiv tonbares photopolymerisierbares Aufzeichnungsmaterial auf die bildseitige Oberfläche eines erfindungsgemäßen Bildträgers auflaminiert, wobei die strahlungsempfindliche Schicht, sowohl im polymerisierten, wie auch im unpolymerisierten Zustand zur Oberfläche des Bildträgers eine größere Haftung aufweist als zum Schichtträger.

Dann wird das Material durch den transparenten Schichtträger hindurch unter Verwendung eines gerasterten Farbauszugs-Positivs einer ersten Farbe als Vorlage mit aktinischer Strahlung zur Ausbildung nicht klebriger Bereiche belichtet. Sodann wird der Schichtträger durch Delaminieren entfernt. Das auf dem Bildträger erzeugte latente Bild wird durch Aufbringen eines Toners, der ausschließlich auf den unbelichteten Schichtteilen haftet, sichtbar gemacht. Der Toner wird von den gehärteten Bildteilen entfernt, die dann völlig frei von Toner sind. Man erhält auf diese Weise ein der Vorlage entsprechendes einfarbiges Farbprüfbild.

Ein zweites Laminat des photopolymerisierbaren Materials wird nach der Entfernung der Deckfolie auf das Bild auflaminiert und unter gleichen Bedingungen durch ein Farbauszugs-Positiv einer zweiten Farbe als Vorlage belichtet und getont. Dieser Vorgang wird dann für einen Farbauszug einer dritten Farbe und, falls erwünscht, für einen Schwarzauszug wiederholt.

Man erhält auf diese Weise ein den Vorlagen entsprechendes mehrfarbiges Farbprüfbild.

Anschließend kann auf das entsprechenden ein- oder mehrfarbige Farbprüfbild eine Schutzschicht aufgebracht werden, die z.B. aus einem weiteren Laminat des photohärtbaren strahlungsempfindlichen Materials besteht, von dem nach flächenmäßiger Belichtung der Schichtträger entfernt wird.

Bei der Verwendung eines negativ tonbaren, bei Bestrahlung klebrig werdenden Aufzeichnungsmaterials ist die Durchführung eines Farbprüfverfahrens ganz analog, nur daß anstelle von Farbauszugs-Positiven Farbauszugs-Negative verwendet werden.

### Ausführungsbeispiele:

### Beispiel 1:

Von verschiedenen Bildträgern wurde jeweils die gemittelte Rauhtiefe Rz in µm der bildempfangenden Oberfläche nach DIN 4768, Blatt 1 mit Hilfe eines Hommel Tester T20-DC (Hommelwerke GmbH, D-7730 Schwenningen) mit dem Meßfühler TKL 100 ermittelt.

Anschließend wurden die Bildträger auf ihrer bildempfangenden Oberfläche jeweils mit einer 4 µm dicken positiv arbeitenden, tonbaren photohärtbaren Mischung, wie in Beispiel 1 der EP-B 02 43 933 beschrieben, beschichtet und in einem Belichtungsgerät durch eine gerasterte Vorlage mit aktinischem Licht belichtet. Die gerasterte Vorlage wurde mit Hilfe eines üblichen Verfahrens zur Herstellung von frequenzmodulierten Rastern mit einem Rasterpunktdurchmesser von 14 µm hergestellt. Die Belichtung erzeugt bildmäßig verteilte klebrige und nichtklebrige Stellen. Die klebrigen Stellen wurden danach mittels einer Cyanfarbfolie getont. Die so hergestellten Farbprüfbilder wurden auf die getreue Wiedergabe der Vorlage hin untersucht.

Ein vorlagengetreue Wiedergabe besteht, wenn alle Rasterpunkte der Vorlage auch auf dem Prüfbild vorhanden sind. In Tabelle 1 sind die verwendeten Bildträger und das Prüfergebnis dargestellt. V1 bis V7 sind bekannte Bildträger für Farbprüfverfahren mit einem Substrat aus Papier. E1 ist eine weiß eingefärbte, 250 µm dicke, opake Polyethylentherephtalatfolie (Melinex 347, ICI), E2 ist ein Bildträger mit einem, aus Papier und einer weiß eingefärbten Polyethylentherephtalatfolie (Melinex 347, ICI mit einer Dicke von 175 µm) zusammengesetzten Substrat wobei sich die Polyesterfolie auf der bildtragende Seite des Bildträgers befindet.

**Tabelle 1**

| Material: | gemittelte Rauhigkeit [µm]: | vorlagengetreue Wiedergabe: | |
|---|---|---|---|
| V1 (CP 320-96, Du Pont) | 5,17 | nein | Vergleich |
| V2 (CR/S-1, Du Pont) | 2,77 | nein | Vergleich |
| V3 (LDG Papier, Du Pont) | 2,47 | nein | Vergleich |
| V4 (ES-96, Du Pont) | 1,20 | nein | Vergleich |
| E1 (Melinex 347, 250 µm dick) | 0,25 | ja | Erfindung |
| E2 (Melinex 347, 175µm dick, auf CP 320-96 aufgebracht) | 0,37 | ja | Erfindung |
| V5 (3M Matchprint) | 3,03 | nein | Vergleich |
| V6 (FUJI ColorArt) | 2,04 | nein | Vergleich |
| V7 (AGFAPROOF) | 4,81 | nein | Vergleich |

### Beispiel 2:

Zur Herstellung eines mehrfarbigen Farbprüfbildes wurde ein Aufzeichnungsmaterial und pigmentierte Übertragungsschichten der Farben Cyan, Magenta, Gelb und Schwarz nach der Angabe des Beispiels 12 der DE-C 39 41 493 verwendet. Eine erste 4 µm dicke positiv arbeitende, tonbare photohärtbare Mischung wie im Beispiel 1 beschrieben wurde nach Entfernung der Deckfolie auf einen Bildträger E1 aus Beispiel 1 auflaminiert und durch einen gerasterten positiven Cyan-Farbauszug in einem Vakuumkopierrahmen mit einer Metallhalogenidlampe (3 000 Watt) unter Verwendung eines ultraviolett-durchlässigen Filters 42 s im Abstand von 95 cm belichtet. Nach Entfernung des Schichtträgers wird die Cyan-Übertragungsschicht auf die bildmäßig belichtete Schicht auflaminiert und sofort wieder abgezogen. Die Übertragungsschicht bleibt nur auf den unbelichteten, klebrigen Stellen haften, und man erhält ein positives Cyanbild der Vorlage.

Eine zweite 4 µm dicke positiv arbeitende, tonbare photohärtbare Mischung, wie im Beispiel 1 beschrieben wird nach Entfernung der Deckfolie auf das Cyanbild auflaminiert und wie oben durch den entsprechenden gerasterten Magenta-Farbauszug belichtet. Nach Entfernung des Schichtträgers wird die Magenta-Übertragungsschicht auf die bildmäßig belichtete Schicht auflaminiert und wieder abgezogen. Die Übertragungsschicht bleibt nur an den unbelichteten klebrigen Stellen haften, und man erhält ein positives Magentabild. Für die Farben Gelb und Schwarz werden die Arbeitsschritte entsprechend wiederholt und anschließend in üblicher Weise eine Schutzschicht aufgebracht. Man erhält einen vierfarbiges Farbprüfbild von ausgezeichneter Brillanz und Schärfe mit einer Auflösung von 1% - 99% im 100-Linien/cm-Raster, das eine naturgetreu Wiedergabe des Originals darstellt. Die Haftung der Aufzeichnungsschichten auf dem Bildträger war ausgezeichnet. Das entstandene Mehrfarbenbild wies die geforderte hohe Auflösung auf.

## Patentansprüche

1. Ein- und mehrfarbige Farbprüfbilder, umfassend einen Bildträger aus einem zweiseitigen, gegebenfalls beschichteten, Substrat und darauf aufgebracht mindestens eine bildmäßig eingefärbte und/oder angefärbte oder eine bildmäßig strukturierte, gegebenenfalls Farbmittel enthaltende Aufzeichnungsschicht, dadurch gekennzeichnet, daß der Bildträger auf seiner bildseitigen Oberfläche eine gemittelte Rauhtiefe Rz von maximal 1,1 µm aufweist.

2. Ein- und mehrfarbige Farbprüfbilder nach Anspruch 1, dadurch gekennzeichnet, daß der Bildträger auf seiner bildseitigen Oberfläche eine gemittelte Rauhtiefe Rz von maximal 0,6 µm aufweist.

3. Ein- und mehrfarbige Farbprüfbilder nach Anspruch 1 oder 2, dadurch gekennzeichnet, daß das Substrat des Bildträgers aus einer weiß eingefärbten Kunststoffolie mit einer Dicke von 50 µm bis 500 µm oder aus einem beschichteten Papier mit einem Flächengewicht zwischen 50 g/m² und 500 g/m² oder aus einer Kombination einer, gegebenenfalls weiß eingefärbten Kunststoffolie und einem gegebenenfalls beschichteten Papier mit einer Dicke von 50 µm bis 600 µm besteht.

4. Verfahren zur Herstellung von ein- und mehrfarbigen Farbprüfbildern von Vorlagen mit hoher Auflösung, umfassend die Verfahrensschritte:
a) auf einen Bildträger gemäß einem der Ansprüche 1 bis 3 wird eine strahlungsempfindliche Aufzeichnungsschicht auf einem transparenten gegebenenfalls eingefärbten Schichtträger so aufgebracht, daß die strahlungsempfindliche Schicht in Kontakt zu der bildseitigen Oberfläche des Bildträgers steht,
b) die strahlungsempfindliche Schicht wird bildmäßig durch eine Vorlage mit hoher Auflösung belichtet,
c) die Aufzeichnungsschicht wird entwickelt ,
d) die Schritte a) bis c) werden gegebenenfalls mehrfach wiederholt, wobei unter a) die neue strahlungsempfindliche Aufzeichnungsschicht auf die gemäß den vorhergehenden Schritten behandelte strahlungsempfindliche Schicht aufgebracht wird.

5. Verfahren zur Herstellung von ein- und mehrfarbigen Farbprüfbildern, bei dem
a) auf einen Bildträger gemäß einem der Ansprüche 1 bis 3 eine strahlungsempfindliche Aufzeichnungsschicht auf einem transparenten Schichtträger so aufgebracht wird, daß die strahlungsempfindliche Aufzeichnungsschicht in Kontakt zur bildseitigen Oberfläche des Bildträgers steht,
b) die strahlungsempfindliche Schicht durch den Schichtträger bildmäßig durch eine Vorlage mit hoher Auflösung belichtet wird,
c) der Schichtträger abgezogen wird und
d) auf die klebrigen Bereiche der belichteten Schicht ein Tonermaterial aufgebracht wird,
e) die Schritte a) bis d) gegebenenfalls mehrfach wiederholt werden, wobei unter a) die neue strahlungsempfindliche Aufzeichnungsschicht auf die gemäß den
vorhergehenden Schritten behandelte strahlungsempfindliche Schicht aufgebracht wird.

6. Verfahren nach Anspruch 5, dadurch gekennzeichnet, daß vor dem bildmäßigen Belichten der Schichtträger entfernt wird.

## Claims

1. Monochromatic and polychromatic color proofs, comprising an image carrier consisting of a twosided, optionally coated, substrate and applied thereon an imagewise colored and/or toned or an imagewise structured recording layer, optionally containing a dye,
characterized in that the image carrier has an average roughness Rz of 1.1 µm at maximum on his image-side surface.

2. Monochromatic and polychromatic color proofs according to claim 1, characterized in that ,
the image carrier has an average roughness Rz of 0.6 µm at maximum on his image-side surface.

3. Monochromatic and polychromatic color proofs according to claim 1 or 2, characterized in that,
the substrate of the image carrier consists of a white-colored synthetic resin sheet with a thickness of 50 µm to 500 µm or of a coated paper weighing between 50 g/m² and 500 g/m² or a combination of an optionally white-colored synthetic resin sheet and an optionally coated paper having a total thickness of 50 µm to 600 µm.

4. Process for the production of monochromatic and polychromatic color proofs of high resolution masters, comprising the process steps:
a) a radiation-sensitive recording layer on a transparent, optionally colored support is applied onto an image carrier according to one of claims 1 to 3 so that the radiation-sensitive layer is in contact with the image-side surface of the image carrier,
b) the radiation-sensitive layer is exposed imagewise through a high resolution master,
c) the recording layer is developed,
d) steps a) to c) are repeated optionally, whereby in a) the new radiation-sensitive recording layer is applied onto the radiation-sensitve layer processed according to the preceding steps.

5. Process for the production of monochromatic and polychromatic color proofsin which
a) a radiation-sensitive recording layer on a transparent support is applied onto an image carrier according to one of claims 1 to 3 so that the radiation-sensitive layer is in contact with the image-side surface of the image carrier,
b) the radiation-sensitive layer is exposed through the support imagewise through a high resolution master,
c) the support is peeled away,
d) a toner is applied on the tacky areas of the exposed layer, and
e) steps a) to d) are repeated optionally, whereby in a) the new radiation-sensitive recording layer is applied onto the radiation-sensitve layer processed according to the preceding steps.

6. Process according to claim 5, characterized in that, the support is removed before imagewise exposure.

## Revendications

1. Epreuves de contrôle de couleur monochromatiques et polychromatiques, comprenant un support d'image à partir d'un substrat à deux côtés, le cas échéant revêtu et appliquée sur celui-ci, au moins une couche d'enregistrement colorée et/ou teintée ou une couche de transfert structurée selon l'image, contenant le cas échéant un colorant, caractérisées en ce que le support d'image présente sur sa surface côté image une rugosité moyenne Rz de maximum 1,1 µm.

2. Epreuves de contrôle de couleur monochromatiques et polychromatiques suivant la revendication 1, caractérisée en ce que le support d'image présente sur sa surface côté image une rugosité moyenne Rz de maximum 0,6 µm.

3. Epreuves de contrôle de couleur monochromatiques et polychromatiques suivant la revendication 1 ou 2, caractérisées en ce que le substrat du support d'image est constitué d'un film de matière synthétique d'une épaisseur de 50 µm à 500 µm coloré en blanc ou d'un papier revêtu avec un grammage entre 50 m²/g et 500 m²/g ou d'une combinaison, d'un film de matière synthétique le cas échéant coloré en blanc et d'un papier le cas échéant revêtu d'une épaisseur de 50 µm à 600 µm.

4. Procédé de préparation d'épreuves de contrôle de couleur monochromatiques et polychromatiques à partir d'originaux à haute résolution, comprenant les étapes de procédé:
a) une couche d'enregistrement photosensible sur un support transparent, le cas échéant, coloré, est appliquée sur le support d'image suivant les revendications 1 à 3 de telle manière que la couche photosensible soit en contact avec la surface côté image du support d'image,
b) la couche photosensible est exposée selon l'image à travers un original à haute résolution,
c) la couche d'enregistrement est développée,
d) les étapes a) à c) sont, le cas échéant, répétées plusieurs fois, en a)la nouvelle couche d'enregistrement photosensible étant appliquée sur la couche photosensible traitée suivant les étapes précédentes.

5. Procédé pour la préparation d'épreuves de contrôle de couleur monochromatiques et polychromatiques,
a) une couche d'enregistrement photosensible sur un support transparent suivant les revendication 1 à 3 étant appliquée sur le support d'image de telle manière que la couche d'enregistrement soit en contact avec la surface côté image du support d'image,
b) la couche photosensible étant exposée à travers le support, selon l'image à travers un original à haute résolution,
c) le support étant retiré et
d) un matériau de toner étant appliqué sur les zones adhésives de la couche exposée,
e) les étapes a) à d) étant, le cas échéant, répétées plusieurs fois, en a)la nouvelle couche d'enregistrement photosensible étant appliquée sur la couche photosensible traitée suivant les étapes précédentes.

6. Procédé suivant la revendication 5, caractérisé en ce que le support est enlevé avant l'exposition selon l'image.
